(19) **Europäisches Patentamt**

**European Patent Office**

**Office européen des brevets**

(11) **EP 1 638 139 A1**

(12) **EUROPEAN PATENT APPLICATION**
published in accordance with Art. 158(3) EPC

(43) Date of publication:
22.03.2006 Bulletin 2006/12

(51) Int Cl.:
*H01L 21/31* (1974.07)   *H01L 21/3065* (1995.01)
*C23C 16/505* (2000.01)   *C23F 4/00* (1985.01)
*H05H 1/46* (1980.01)

(21) Application number: 04733924.7

(22) Date of filing: 19.05.2004

(86) International application number:
PCT/JP2004/006738

(87) International publication number:
WO 2004/102650 (25.11.2004 Gazette 2004/48)

(84) Designated Contracting States:
NL

(30) Priority: 19.05.2003 JP 2003141045

(71) Applicant: TOKYO ELECTRON LIMITED
Minato-ku,
Tokyo 107-8481 (JP)

(72) Inventors:
• MATSUURA, Hiroyuki,
Tokyo Electron Limited
Tokyo 1078481 (JP)

• KATO, Hitoshi,
Tokyo Electron Limited
Tokyo 1078481 (JP)

(74) Representative: De Hoop, Eric
Octrooibureau Vriesendorp & Gaade B.V.
P.O. Box 266
2501 AW  Den Haag (NL)

(54) **PLASMA PROCESSING DEVICE**

(57)     The invention is intended, in a vertical type plasma processing apparatus, to prevent damage to process objects due to a plasma, and to suppress the generation of sputter due to hollow cathode discharge and the plasma, without lowering the radical utilization efficiency. A part of the inner surface of the side wall of a processing vessel 32 is provided with a vertically extending recess 74. A plasma gas supplied from a plasma gas nozzle 62 disposed in the recess 74 is converted into a plasma in an area PS between plasma electrodes 76 in the recess 74, and leaves the recess 74 toward the process objects W.

F I G. 3

## Description

TECHNICAL FIELD

The present invention relates to a plasma processing apparatus for performing a plasma process to process objects such as semiconductor wafers at a relatively low temperature.

BACKGROUND ART

In general, when fabricating a semiconductor integrated In general, when fabricating a semiconductor integrated circuit, various processes, such as a film forming process, an etching process, an oxidation process, a diffusion process, a modification process and a natural oxide film removing process, are performed to a semiconductor wafer of a silicon substrate. When these processes are carried out by a vertical, or a so-called batch type heat treatment apparatus, wafers are transferred from a cassette, capable of holding plural, e.g., 25 wafers therein, to a vertical wafer boat so that the wafer boat holds the wafers at multiple levels. A wafer boat is capable of holding about 30 to 150 pieces of wafers, although the capacity thereof depends on the wafer size. The wafer boat is loaded into a processing vessel, which is adapted to be evacuated, from below the processing vessel, and then the processing vessel is maintained in a hermetically-closed condition. The wafers are subjected to a predetermined heat treatment, while various process conditions, such as the flow rates of the process gases, the process pressure and the process temperature, are controlled.

In view of the recent demand for higher degree of integration and further miniaturization of semiconductor integrated circuit, reduction in thermal history in the manufacturing process steps is required in order to improve the properties of circuit elements. Under the circumstances, also in vertical, batch type processing apparatuses, the use of a plasma process, which achieves a required treatment without exposing wafers to a high temperature, has been proposed.

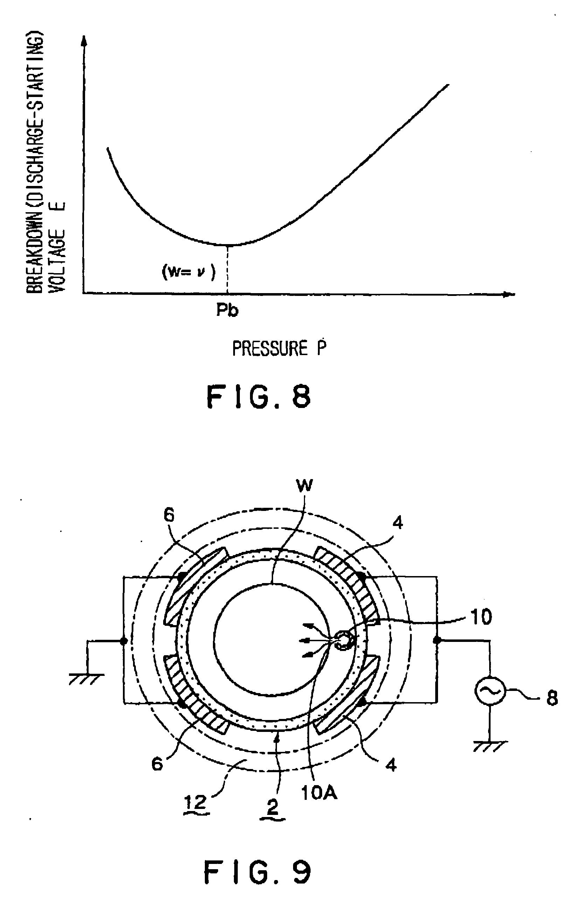

Fig. 9 is a transverse sectional view schematically showing the structure of a plasma processing apparatus disclosed in JP3-224222A. In this plasma processing apparatus, diametrically opposed two pairs of electrodes 4, 6 are arranged outside a side wall of a cylindrical processing vessel 2 which can be evacuated. A high frequency power supply 8 is connected to first pair of electrodes 4, while second pair of electrodes 6 are connected to ground. A plasma can be generated in the whole area of the interior of the processing vessel 2 by applying a high frequency voltage across the electrodes 4 and 6. Semiconductor wafers are held in the central area of the processing vessel 2 at multiple levels. A gas nozzle 10 for supplying a gas for plasma generation is arranged on one side of the processing vessel 2. The wafers W are subjected to a plasma process while the wafers W are maintained at a predetermined temperature by means of a heater 12 disposed on an outer periphery of the processing vessel 2.

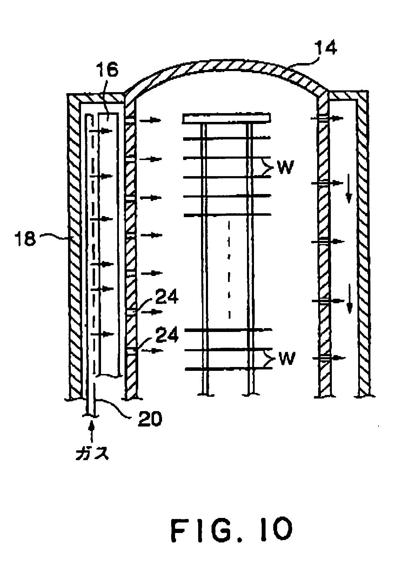

Fig. 10 is a longitudinal sectional view schematically showing the structure of a plasma processing apparatus disclosed in JPS-251391A and JP2002-280378A. This plasma processing apparatus is of a so-called "remote plasma" type, and is configured so that a plasma is generated in a separated area in a vertical processing vessel which can be evacuated, or in an area outside the processing vessel, and a radial thus generated is supplied to wafers. In the illustrated structure of Fig. 10, a plasma generating vessel 18 is arranged outside a side wall of a cylindrical processing vessel 14. Electrodes 16, to which a high frequency voltage is applied, and a process gas supply pipe 20 are arranged in the vessel 18. A radical generated in the plasma generating vessel 18 is supplied to wafers W in the processing vessel 14 through plural radial supply ports 24 of a small diameter formed in the side wall of the processing vessel 14, thereby a plasma process is carried out.

The plasma processing apparatuses of Figs. 9 and 10 are advantageous in that they can perform a desired treatment even if the process temperature is relatively low, due to the use of a plasma. However, these prior-art apparatuses have the following disadvantages. That is, in the plasma processing apparatus of Fig. 9, as the wafers W are directly exposed to a plasma, the plasma may seriously damage the wafer surfaces. In addition, as the electrodes 4 and 6 arranged around the processing vessel 2 generate a large amount of heat, the accuracy of the wafer temperature control performed by the heater 12 arranged outside the electrodes 4 and 6 may be degraded.

Further, as the gas nozzle 10 made of quartz is located in an electric field generated between the electrodes 4 and 6, the gas nozzle 10 is sputtered by a plasma to generate particles, resulting in defects in circuit elements. Moreover, impurities decomposed by the sputter are introduced into deposition films on the wafers W. Further, as a large pressure difference exists near the gas holes 10A of a small diameter through which a plasma gas or a process gas is supplied, so-called "hollow cathode discharge" is generated, and thus the quartz gas nozzle 10 is sputtered, resulting in the same problem as mentioned above.

The plasma processing apparatus of Fig. 10 employs a remote plasma method, in which a radial is generated in the plasma generating vessel 18, and the radial is supplied to the wafers W through plural radical supply ports 24 of a small diameter formed in a partition wall separating the processing vessel 14 and the plasma generating vessel 18 from each other. Thus, part of the generated radical is deactivated before reaching wafers W, and thus it is difficult to achieve a high radical concentration in areas near the wafers W. Further, as the radical supply ports 24 are located near the electrodes 16, hollow cathode discharge is generated near the radical supply ports 24 to sputter the side wall of the quartz processing vessel.

SUMMARY OF THE INVENTION

Accordingly, the object of the present invention is to provide a plasma processing apparatus capable of utilizing a generated radical effectively, while preventing damage to the wafers.

A further object of the present invention is to suppress hollow cathode discharge and sputtering due to plasma.

In order to achieve the objectives, the present invention provides a plasma processing apparatus for performing a plasma process to process objects, which includes: a cylindrical vertical processing vessel adapted to be evacuated; a process object holding means for holding a plurality of process objects in the processing vessel at multiple levels; a heater arranged outside the processing vessel; a plasma gas nozzle that supplies a plasma gas, to be converted into a plasma, into the processing vessel; and plasma electrodes, across which a high frequency voltage is applied, to convert the plasma gas into the plasma, wherein: a recess, extending vertically, is arranged in a part of an inner surface of a side wall of the processing vessel; the plasma gas nozzle is arranged such that the plasma gas nozzle discharges the plasma gas from depths of the recess toward the process objects; and the plasma electrodes are arranged at positions ensuring that the plasma gas discharged from the plasma gas nozzle is converted into the plasma in the recess.

In a preferred embodiment, an exhaust port is formed in a part, opposite to the recess, of the side wall of the processing vessel.

In a preferred embodiment, a cooling device is arranged in the recess or adjacent to the recess to draw heat generated by the plasma electrodes.

In a preferred embodiment, the plasma gas nozzle comprises a tubular member having a plurality of gas jetting holes arranged along a longitudinal direction of the plasma gas nozzle.

In a preferred embodiment, the plasma gas nozzle is arranged at a position remote from a plasma generating area between the plasma electrodes at a distance enough large to prevent generation of hollow cathode discharge.

In a preferred embodiment, a slit plate having a slit, which determines an area of an entrance opening of the recess, is detachably attached to an outlet portion of the recess.

In a preferred embodiment, a non-plasma gas nozzle is provided for supplying a non-plasma gas, not to be converted into a plasma, into the processing vessel. The non-plasma gas nozzle may comprise a tubular member having a plurality of gas jetting holes arranged along a longitudinal direction of the non-plasma gas nozzle. Preferably, the non-plasma gas nozzle is arranged outside the recess and adjacent to an entrance opening of the recess.

In one embodiment, the plasma gas is ammonia gas, the non-plasma gas is a silane-series gas, and the process performed by said plasma processing apparatus is a silicon nitride film forming process by a plasma assisted chemical vapor deposition. The ammonia gas and the silane-series gas may be supplied alternately and intermittently, while a purging period is set between an ammonia gas supplying period and a silane-series gas supplying period.

In one embodiment, the plasma gas is a mixed gas of hydrogen and nitrogen, or ammonia gas; the non-plasma gas is an etching gas; and the process performed by said plasma processing apparatus is a plasma process that removes natural oxide films formed on the process objects. The etching gas may be nitrogen trifluoride gas.

BRIEF DESCRIPTION OF THE DRAWINGS

Fig.1 is a vertical sectional view of a plasma processing apparatus in one embodiment of the present invention;
Fig. 2 is a transverse sectional view showing the structure of the plasma processing apparatus shown in Fig. 1;
Fig. 3 is an enlarged view of a part A in Fig. 2;
Fig. 4 is a perspective view showing the arrangement of plasma electrodes;
Fig. 5 is a timing diagram showing the process gas supply timing;
Fig. 6 is a perspective view showing a slit plate in one example;
Fig. 7 is a transverse sectional view of an opening of plasma generating part to which the slit plate is attached;
Fig. 8 is a graph showing the relationship between the voltage between parallel plate plasma electrodes and the breakdown (discharge-starting) voltage;
Fig. 9 is a transverse sectional view schematically showing a conventional plasma processing apparatus in one example; and
Fig. 10 Is a transverse sectional view schematically showing a conventional plasma processing apparatus in another example:

DESCRIPTION OF THE PREFERRED EMBODIMENTS

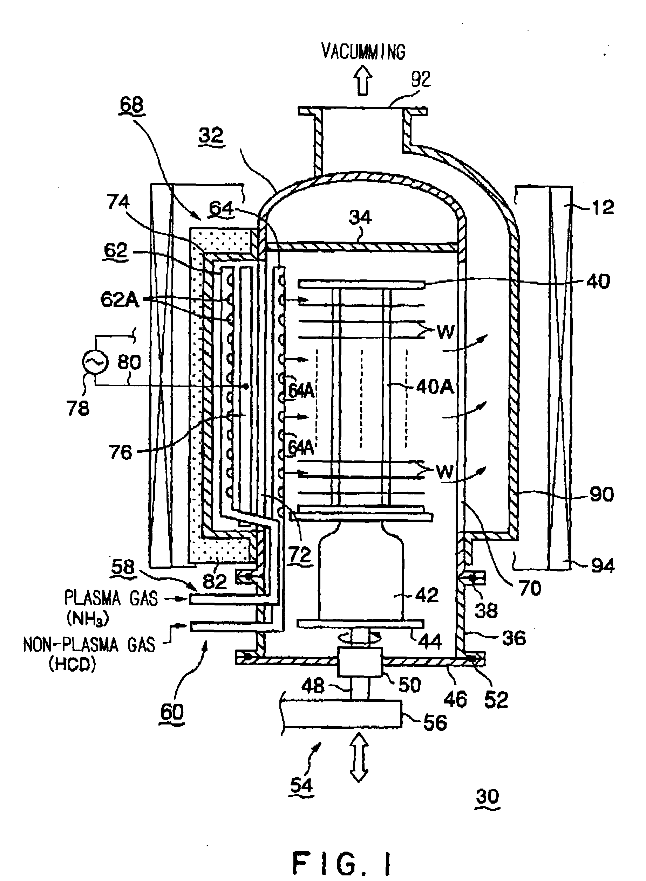

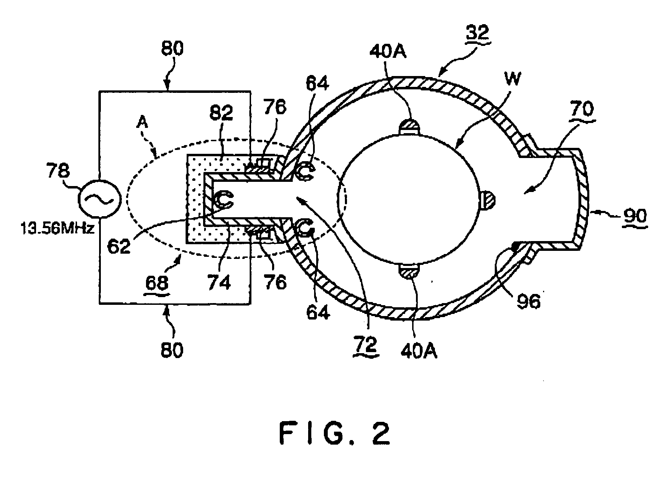

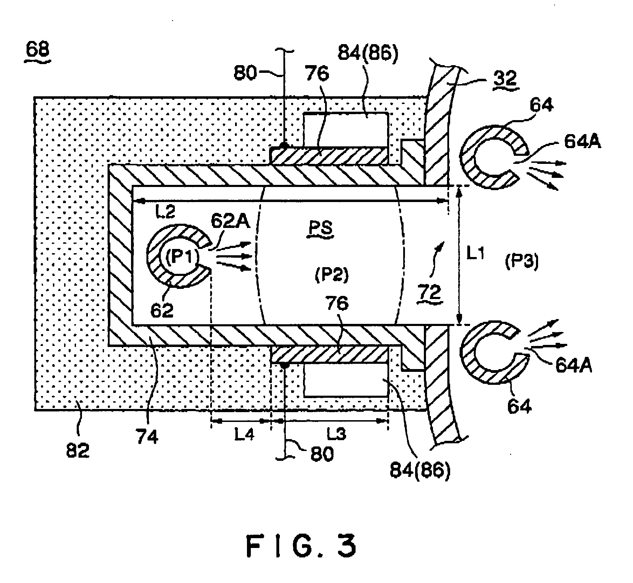

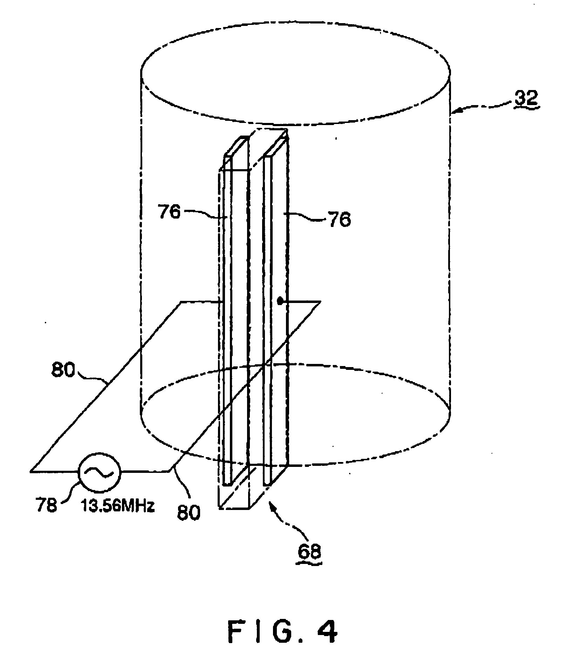

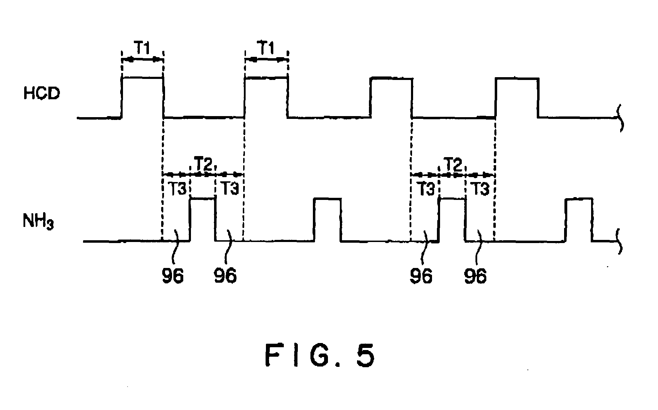

A plasma processing apparatus in one embodiment of the present invention is described in detail below with reference to the accompanying drawings. Fig. 1 is a vertical sectional view of the plasma processing apparatus. Fig. 2 is a transverse sectional view of the plasma processing apparatus (illustration of a heater is omitted). Fig. 3 is an enlarged view of a part A in Fig. 2. Fig. 4 is a perspective view showing the arrangement of plasma electrodes. Fig. 5 is a timing diagram showing the process gas supply timing. Hereinbelow, a film forming process for forming a silicon nitride (SiN) film by a plasma assisted chemical vapor deposition is described by way of example, with the use of ammonia gas as a gas to be converted into a plasma (referred to as "plasma gas" below) and hexachlorodisilane (also referred to as "HCD" below) gas as a gas not to be converted into a plasma (referred to as "non-plasma gas" below).

The plasma processing apparatus 30 includes a cylindrical processing vessel 32 with a ceiling and a lower end opening. The processing vessel 32 is entirely made of quartz. An upper interior part of the processing vessel 32 is sealed by a ceiling plate 34 made of quartz. A cylindrical manifold 36 made of stainless steel is connected to the lower end opening of the processing vessel 32 via a sealing member 38 such as an O-ring. The lower end of the processing vessel 32 is supported by the manifold 36. A wafer boat 40 (i.e., a process object holding means) made of quartz, for holding a plurality of semiconductor wafers W (i.e., process objects) at multiple levels, can be loaded into the processing vessel 32 from a lower part of the manifold 36. In a typical embodiment, columns 40A of the wafer boat 40 are configured to hold thirty pieces of wafers W each having a diameter of 300 mm at multiple levels at substantially regular intervals.

The wafer boat 40 is placed on a table 44 through a heat-insulating tube 42 made of quartz, The table 44 is supported on a rotation shaft 48 passing through a lid 46 made of stainless steel which opens and closes the lower end opening of the manifold 36. A magnetic fluid seal 50 is interposed between the lid 46 and the rotation shaft 48. The seal 50 supports the rotation shaft 48 while hermetically sealing the rotation shaft 48. A sealing member 52 such as an O-ring is interposed between the periphery of the lid 46 and the lower end of the manifold 36 to maintain airtightness of the processing vessel 32. The rotation shaft 48 is mounted on the distal end of an arm 56 supported by an elevating mechanism 54 such as a boat elevator. Thus, the wafer boat 40 moves vertically together with the members connected thereto such as the lid 46, so that the lid 46 is loaded into the processing vessel 32 and unloaded therefrom. The table 44 may be secured on the lid 46. In this case, the wafers W are processed without rotating the wafer boat 40.

The manifold 36 is provided with a plasma gas supplying means 58 for supplying a plasma gas (ammonia, (NH$_3$) gas in this embodiment) toward the interior of the processing vessel 32, and a non-plasma gas supplying means 60 for supplying a non-plasma gas (HCD gas as a silane-series gas in this embodiment) toward the interior of the processing vessel 32. The plasma gas supplying means 58 has a plasma gas distributing nozzle 62 formed of a quartz tube for supplying a plasma gas. The quartz tube forming the nozzle 62 passes horizontally through a side wall of the manifold 36 toward the interior of the processing vessel 32, and then bends to extend upward. The plasma gas distributing nozzle 62 is provided with a plurality of gas jetting holes 62A arranged at predetermined intervals along a longitudinal direction of the plasma gas distributing nozzle 62. The ammonia gas can be substantially uniformly jetted through the gas jetting holes 62A in a horizontal direction. The diameter of each gas jetting hole 62A is about 0.4 mm, for example.

The non-plasma gas supplying means 60 has a non-plasma gas distributing nozzle 64 formed of a quartz tube for supplying a non-plasma gas. The quartz tube forming the nozzle 64 passes horizontally through the side wall of the manifold 36 toward the interior of the processing vessel 32, and then bends to extend upward. In the illustrated embodiment, two non-plasma gas distributing nozzles 64 are disposed (see, Figs. 2 and 3). Each of the non-plasma gas distributing nozzles 64 is provided with a plurality of (many) gas jetting holes 64A arranged along a longitudinal direction of the non-plasma gas distributing nozzle 64 at predetermined intervals. The silane-series gas can be substantially uniformly jetted through the gas jetting holes 64A in a horizontal direction. In place of the two non-plasma gas distributing nozzle 64, only one non-plasma gas distributing nozzle 64 may be provided.

A plasma generating part 68, which is a characteristic feature of the present invention, is arranged in a part of the side wall of the processing vessel 32 along its vertical direction. An elongated exhaust port 70 for evacuating an atmosphere inside the processing vessel 32 is formed in a part, opposite to the plasma generating part 68, of the side wall of the processing vessel 32. The exhaust port 70 can be formed by vertically removing a part of the side wall of the processing vessel 32.

In order to form the plasma generating part 68, a part of the side wall of the processing vessel 32 is vertically removed at a predetermined width, so that a vertically elongated opening 72 is formed. A cover 74 (i.e., a plasma chamber wall 74), having a vertically elongated inner space and having an opening on the processing-vessel side, is hermetically welded to an outer surface of the side wall of the processing vessel 32 so as to cover the opening 72. Thus, a vertically extending recess is formed in a part of an inner surface of the side wall of the processing vessel 32. The opening 72 serves as an entrance of the recess. A plasma chamber wall 74 and a space surrounded by the plasma chamber wall 74 extending inwardly from the opening 72 can be understood as the plasma generating part 68. The opening 72 is formed long enough with respect to the vertical direction so that all the wafers W held by the wafer boat 40 can be covered by the opening 72 with respect to the vertical direction. The opening 72 continuously extends in the vertical direction without any discontinuity from the upper end to the lower end thereof.

A pair of vertically extending plasma electrodes 76, which are opposed to each other, are disposed on outer surfaces of opposite side walls of the plasma chamber wall 74. A high frequency power supply 78 for generating a plasma is connected to the plasma electrodes 76 through a feed line 80. A plasma can be generated by applying a high frequency voltage, whose frequency is such as 13.56 MHz, across the plasma electrodes 76 (see, Fig 4). The frequency of the high frequency voltage is not limited to 13.56 MHz, and another frequency, such as 400 kHz, may be employed.

The plasma gas distributing nozzle 62 extends upward in the processing vessel 32, is radially, outwardly bent to extend to an outermost part (i.e., a part which is most away from the center of the processing vessel 32) of the plasma generating part 68, and then the nozzle 62 extends upward. As best shown in Fig. 3, the plasma gas distributing nozzle 62 is arranged at a position outwardly removed from an area between the pair of plasma electrodes 76, that is, a plasma generating area PS in which a plasma is mainly generated. Therefore, the ammonia gas jetted through the gas jetting holes 62A of the plasma gas distributing nozzle 62 enters the plasma generating area PS, and is decomposed or activated in the area PS. Then, the ammonia gas is dispersed to flow toward the center of the processing vessel 32.

In the illustrated embodiment, width L1 of the opening 72 is 5 to 10 mm, radial length L2 of the plasma generating part 68 is 60 mm, width L3 of the plasma electrode 76 is 20 mm, distance L4 between the plasma electrode 76 and the plasma gas distributing nozzle 62 is 20 mm (see, Fig. 3). Each of the processing vessel 32 and the plasma chamber wall 74 has a thickness of 5 mm.

The exterior of the plasma chamber wall 74 is covered by an insulative protection cover 82 made of quartz. The insulative protection cover 82 is provided with a cooling device 86 formed of refrigerant channels 84 arranged at positions corresponding to rear surfaces of the plasma electrodes 76. When a refrigerant such as cool nitrogen gas flows through the refrigerant channels 84, the plasma electrodes 76 can be cooled. The exterior of the insulation protective cover 82 is covered by a shield, not shown, in order to prevent leakage of a high frequency.

Outside the plasma generating part 68 (inside the processing vessel 32), the two non-plasma gas distributing nozzles 64 vertically extend adjacent to the opening 72. A silane-series gas can be jetted through the respective gas jetting holes 64A of the nozzles 64 toward the center of the processing vessel 32.

An exhaust port covering member 90 having a section of "]" (square bracket) shape is attached to the processing vessel 32 by welding, to cover the exhaust port 70 arranged on the opposite side of the plasma generating part 68. The exhaust port covering member 90 extends upward along the side wall of the processing vessel 32. The interior of the processing vessel 32 can be evacuated, by a not-shown evacuating system including a vacuum pump, through the exhaust port 70 and a gas outlet port 92 formed above the processing vessel 32. A cylindrical heater 94 arranged outside the processing vessel 32 to surround the same to heat the processing vessel 32 and the wafers W contained therein. A thermocouple 96 for controlling the temperature of the heater 94 is disposed adjacent to the exhaust port 70 (see, Fig. 2).

Next, a plasma process carried out by the above-mentioned plasma processing apparatus is described. A plasma process for forming a silicon nitride film on a wafer surface by a plasma assisted chemical vapor deposition is explained by way of example. First, the wafer boat 40 holding a plurality of, for example, 50 wafers of 300 mm in diameter at a room temperature is elevated to be loaded into the processing vessel 32 from below, the vessel 32 having been already heated to a predetermined temperature. By closing the lower end opening of the manifold 36 with the lid 46, the processing vessel 32 is hermetically closed. Then, the interior of the processing vessel 32 is evacuated, and is maintained at a predetermined process pressure; and the electric power supplied to the heater 94 is increased so that the wafer temperature is raised and maintained at a predetermined process temperature. Process gases are alternately and intermittently supplied to the wafers W from the plasma gas supplying means 58 and the non-plasma gas supplying means 60, so that a silicon nitride film is formed on a surface of each wafer W supported by the rotating wafer boat 40.

In more detail, $NH_3$ gas is horizontally jetted through the gas jetting holes 62A of the plasma gas distributing nozzle 62 disposed in the plasma generating part 68, while HCD gas is horizontally jetted through the respective gas jetting holes 64A of the non-plasma gas distributing nozzles 64, so that the gases react with each other to form silicon nitride films. As shown in Fig. 5, the gases are not continuously supplied, but supplied alternately, intermittently and repeatedly at different timings, whereby silicon nitride thin film layers are repeatedly deposited one by one. A purging period 96 (T3) for purging gases remaining in the processing vessel is set between an $NH_3$ gas supplying period T1 and an HCL gas supplying period T2. In a typical embodiment, the HCD gas supplying period T1 is about 5 minutes, the $NH_3$ gas supplying period T2 is about 2 minutes to 3 minutes, and the purging period T3 is about 2 minutes. The purging operation is carried out by causing an inert gas such as $N_2$ gas to flow in the processing vessel. In place thereof, or in addition thereto, the purging operation is carried out by vacuuming the interior of the processing vessel. In the illustrated embodiment, the purging operation is carried out by vacuuming.

$NH_3$ gas jetted from the gas jetting holes 62A of the plasma gas distributing nozzle 62 flows into the plasma generating area PS (see, Fig. 3) between the plasma electrodes 76 to which a high frequency voltage is applied. $NH_3$ gas is converted into a plasma and activated to generate radicals, such as N*, NH*, $NH_2$*, and $NH_3$* (mark * means a radical). These radicals leave the plasma generating part 68 via the opening 72 toward the center of the processing vessel 32, while being dispersed to flow between adjacent wafers W in a form of a laminar flow.

The radicals react with molecules of HCD gas adsorbing to the surface of the wafer W to form a silicon nitride film thereon. On the other hand, when HCD gas is supplied to the surface of the wafer W to which the radicals adsorb, a silicon nitride film is also formed. The process conditions in the plasma assisted chemical vapor deposition process are, for example, as follows: the process temperature is 300°C to 600°C; the process pressure is equal to or less than 1,333 Pa (10 Torr); the flow rate of $NH_3$ gas is equal to or less than 5,000 sccm; and the flow rate of HCD gas is 10 sccm to 80 sccm. The deposition rate is about 0.2 nm/min.

In the conventional plasma processing apparatus as shown in Figs. 9 and 10, hollow cathode discharge is generated in the gas holes of the gas nozzle and the radical gas inlet port. However, in this embodiment, the plasma generating part 68 (i.e., the inner space of the recess) communicates with a processing part (i.e., the inner space of the processing vessel 32 excluding the plasma generating part 68) of the processing vessel 32 via the opening 72 having a sufficiently large opening area. Thus, rapid change in the gas pressure in the vicinity of the opening 72 with respect to the gas-flow direction can be prevented. In other words, "throttle effect" is not occurred near the opening 72 serving as an outlet of the gas from the recess. Therefore, generation of hollow cathode discharge can be prevented near the opening 72. Further, the plasma gas distributing nozzle 62 is remote from the plasma electrodes 76 or the plasma generating area PS at the predetermined distance L4 (see, Fig 3). Thus, generation of hollow cathode discharge can also be prevented at an area near the gas jetting holes 62A of the plasma gas distributing nozzle 62 where hollow cathode discharge is likely to occur, As a result, the plasma gas distributing nozzle 62 and the wall surface of the processing vessel 32, which are made of quartz, are prevented from being sputtered by the hollow cathode discharge, generation of particles originated from a quartz material can be prevented.

As a plasma is locally generated in the plasma generating part 68, the plasma does not reach the wafers W, which prevents the wafers W from being damaged by the plasma. Meanwhile, a radical generated in the plasma generating part 68 is supplied toward the wafers W through the opening 72 having a sufficiently large opening area. Thus, unlike in a case of using a conventional processing apparatus of a remote plasma type, the radical can be supplied to the wafers W without disappearance or deactivation of the radical. Accordingly, the plasma process efficiency can be improved.

Moreover, as a heat generated by the plasma electrode 76 is cooled by the cooling device 86, it can be prevented that the heat generated in the plasma electrode 76 exercises an adverse effect on a temperature control of the wafers W. Further, as the thermocouple 96 (see, Fig. 2) for controlling the wafer temperature is disposed far away from the plasma electrodes 76, superposition of a high frequency noise to an output signal of the thermocouple 96 is prevented, so that a temperature of the wafers W can be controlled with a high precision.

In the above-mentioned embodiment, HCD gas is used as a silane-series gas. However, not limited thereto, other silane-series gas such as monosilane [$SiH_4$], disilane [$Si_2H_6$], dichlorosilane [DCS], hexamethyldisilazane (HMDS), tetrachlorosilane (TCS), disilylamine (DSA), trisilylamine (TSA), or bis-tertiary butylaminosilane (BTBAS) may be used as the silane-series gas.

In the above-mentioned embodiment, the width L1 of the opening 72 of the plasma generating part 68 (i.e., the width of the entrance opening of the plasma generating part 68 or the recess) is fixed. However, there may be a case in which the width of the entrance opening is desired to be changed in accordance with the sort of the process or the process conditions. In order that the width of the entrance opening can be readily changed, it can be considered that a sufficiently large-sized opening 72 is formed in the processing vessel 32, and a slit plate is detachably attached to the opening 72. With the provision of a plurality of slit plates having different slit width, the width of the entrance opening can be readily changed by changing the slit plates.

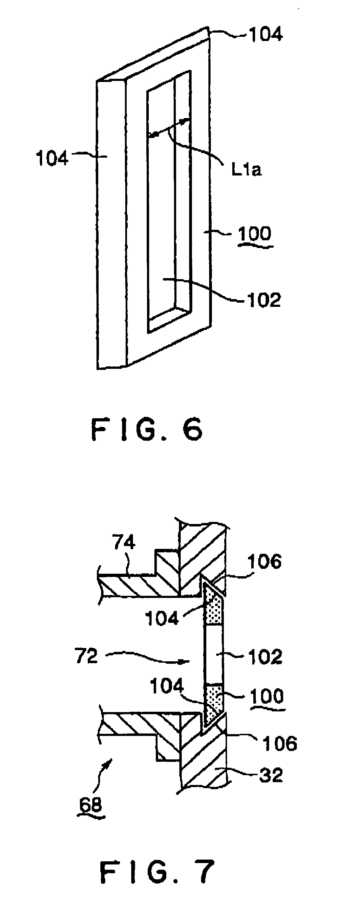

Fig. 6 is a perspective view showing a slit plate in one example. Fig. 7 is a transverse sectional view of the opening of plasma generating part 68 to which the slit plate is attached. The slit plate 100 is a relatively thin (for example, about 3 mm in thickness) quartz plate. A slit 102 allowing a gas to pass therethrough is formed in a center part of the slit plate 100. The slit 102 is of a wide through-hole which extends in a vertical direction of the slit plate 100. Tapered surfaces 104 for attachment are formed on opposite sides of the slit plate 100. Recesses 106 each having a triangular section, in which the tapered surfaces 104 are fitted, are formed in parts, near the opening 72, of the processing vessel 32. The slit plate 100 can be detachably fixed to the opening 74 by vertically sliding the slit plate 100, with the tapered surfaces 104 being fitted in the recesses 106. A plurality of slit plates 100 having the slits 102 of different widths L1a are previously prepared, and one slit plate 100 with the slit 102 of the optimum width L1a is selected depending on process conditions or the like.

By selecting the optimum slit plate 100, generation of hollow cathode discharge is prevented, and also the generated plasma is effectively prevented from reaching the wafer W. Consequently, the wafers W can be prevented from being damaged by the plasma.

Conditions for preventing the generation of hollow cathode discharge were examined. The result is explained below. While a high frequency voltage is applied across plate-shaped plasma electrodes arranged in parallel, a breakdown (discharge-starting) voltage is changed upon change of a pressure between the plasma electrodes. The relationship between the voltage P between the plasma electrodes and the breakdown voltage E are as shown in Fig. 8, in general. That is, the characteristic curve shown in Fig. 8 is concave downward, and the breakdown voltage takes the minimum value at pressure Pb.

Here, an electron in an electric field of a high frequency having the amplitude Ep (effective value E) and the angular frequency $\omega$ is considered. When the pressure between the electrodes is P, and the collision frequency of an electron and a neutral particle is $\nu$, the motion equation of the electron is expressed by the following equation.

$$m_e \cdot dV / dt = e \cdot \sqrt{2} \exp(i\omega t) - m_e \nu V$$

where $m_e$ is the mass of the electron, V is the kinetic rate of the electron, and e is the charge of the electron. Based on the equation, the moving velocity of the electron is expressed by the following equation.

$$V = \{e\sqrt{2}Em_e(i\omega + \nu)\}\exp(i\omega t)$$

An average energy W obtained by an electron group from the high frequency electric filed per unit time is expressed by the following equation, in which the electron density is represented by $n_e$.

$$W = \mathrm{Re}\left[\{-(en_eV)^* \sqrt{2}\exp(i\omega t)\}/2\right]$$
$$= (n_e e^2 / m_e \nu)\{\nu^2 /(\nu^2 + \omega^2)\}E^2$$
$$= (n_e e^2 / m_e)\{\nu /(\nu^2 + \omega^2)\}E^2$$

where "Re" means the real part in the bracket [ ], and "( )*" means the conjugate complex number in the bracket ( ).

Suppose $K = \nu / (\nu^2 + \omega^2)$, when K takes the maximum value, the breakdown voltage E takes the minimum value. These conditions are satisfied when $\omega$ is substantially equal to $\nu$.

The pressure P between the electrodes at this moment in the plasma generating part 68 is depicted by P2 (see, Fig. 3). The pressure in the plasma gas distributing nozzle 62 is depicted by P1, and the pressure outside the plasma generating part 68 (in the processing vessel 32) is depicted by P3.

When the relationship $\omega \gg \nu$ is established with the increase in the pressure P between the electrodes, the relationship $K = \nu / (\nu^2 + \omega^2) \approx 1$ is established, so that the breakdown voltage E increases. Thus, the pressure P1 in the plasma gas distributing nozzle 62 and the distance L4 (see, Fig. 3) between the nozzle 62 and the plasma electrodes 76 are set such that the above conditions can be achieved, so as not to generate an electric discharge in the plasma gas distributing nozzle 62. As a result, generation of hollow cathode discharge in the gas jetting holes 62A can be prevented. When the pressure P between the electrodes is smaller than P2, if the relationship $\omega \ll \nu$ is established, the relationship $W \propto \nu E^2$ is established. Accordingly, by setting the pressure P3 in areas near the wafer. W to satisfy the relationship P3 < P2 < P1, generation of hollow cathode discharge can be prevented. That is, the width L1 of the opening 72 and the width L1a of the slit 102 allowing a gas to pass therethrough are determined such that the above conditions can be achieved.

In the aforementioned embodiment, the description is made for an example in which a silicon nitride film is formed by a plasma assisted chemical vapor deposition. However, another sort of film may be formed by a plasma assisted chemical vapor deposition. Further, a process carried out by the above plasma processing apparatus is not limited to the plasma assisted chemical vapor deposition process. Other processes, such as a plasma etching process, a plasma ashing process, a plasma cleaning process may be carried out. In these cases, if more sorts of gases are required, additional gas distributing nozzles may be disposed in the apparatus. Further, a process may be carried out by using a mixed gas by simultaneously supplying required process gases (plasma gas and non-plasma gas) from respective gas distributing nozzles. Also in this case, the non-plasma gas distributing nozzle 64 disposed adjacent to the outlet of the gas of the opening 72 enhances an efficiency in mixing a radical generated by the plasma gas, and the non-plasma gas.

When a cleaning process is carried out for removing a natural oxide ($SiO_2$) film formed partially or entirely on surfaces of wafers W of silicon substrates, the plasma gas and the non-plasma gas are simultaneously supplied and mixed with each other. In this cleaning process, the plasma gas jetted from the plasma gas distributing nozzle 62 may be a mixed gas of hydrogen and nitrogen, or ammonia gas. The non-plasma gas jetted from the non-plasma gas distributing nozzle 64 may be nitrogen trifluoride ($NF_3$) gas. This plasma cleaning process can be carried out for cleaning an inner wall surface of the processing vessel 32 and structures contained in the processing vessel 32.

The plasma processing apparatus according to the present invention can be applied to a plasma process for improving a dielectric constant of an organic insulation film. In place of heating to sinter an organic interlaminar insulation film of a low dielectric constant, such as an MSQ (Methyl Silsequiozane) based film and an HSQ (Hydrogen Silsequioxane) based film, formed by an SOG (Spin On Glass) method or a CVD method, such a film may be subjected to a plasma process by means of a plasma of hydrogen or ammonia gas by using the plasma processing apparatus according to the present invention. For example, the organic insulation film was subjected to a plasma process for 30 minutes by using a plasma (active species) of hydrogen gas. After the plasma process, a dielectric constant of the insulation film was improved to be 2.40, while the dielectric constant before the process was 2.55. In addition, a process object is not limited to a semiconductor wafer, but may be another substrate such as a glass substrate, an LCD substrate, and so on.

## Claims

1. A plasma processing apparatus for performing a plasma process to process objects, comprising:

   a cylindrical vertical processing vessel adapted to be evacuated;
   a process object holding means for holding a plurality of process objects in the processing vessel at multiple levels;
   a heater arranged outside the processing vessel;
   a plasma gas nozzle that supplies a plasma gas, to be converted into a plasma, into the processing vessel; and
   plasma electrodes, across which a high frequency voltage is applied, to convert the plasma gas into the plasma,

   wherein:

   a recess, extending vertically, is arranged in a part of an inner surface of a side wall of the processing vessel;
   the plasma gas nozzle is arranged such that the plasma gas nozzle discharges the plasma gas from depths of the recess toward the process objects; and
   the plasma electrodes are arranged at positions ensuring that the plasma gas discharged from the plasma gas nozzle is converted into the plasma in the recess.

2. The plasma processing apparatus according to claim 1, wherein an exhaust port is formed in a part, opposite to the recess, of the side wall of the processing vessel.

3. The plasma processing apparatus according to claim 1, wherein a cooling device is arranged in the recess or adjacent to the recess to draw heat generated by the plasma electrodes.

4. The plasma processing apparatus according to claim 1, wherein the plasma gas nozzle comprises a tubular member having a plurality of gas jetting holes arranged along a longitudinal direction of the plasma gas nozzle.

5. The plasma processing apparatus according to claim 1, wherein the plasma gas nozzle is arranged at a position remote from a plasma generating area between the plasma electrodes at a distance enough large to prevent generation of hollow cathode discharge.

6. The plasma processing apparatus according to claim 1, wherein a slit plate having a slit, which determines an area of an entrance opening of the recess, is detachably attached to an outlet portion of the recess.

7. The plasma processing apparatus according to claim 1 further comprising a non-plasma gas nozzle that supplies a non-plasma gas, not to be converted into a plasma, into the processing vessel.

8. The plasma processing apparatus according to claim 7, wherein the non-plasma gas nozzle comprises a tubular member having a plurality of gas jetting holes arranged along a longitudinal direction of the non-plasma gas nozzle.

9. The plasma processing apparatus according to claim 8, wherein the non-plasma gas nozzle is arranged outside the recess and adjacent to an entrance opening of the recess.

10. The plasma processing apparatus according to claim 7, wherein the plasma gas is ammonia gas, the non-plasma gas is a silane-series gas, and the process performed by said plasma processing apparatus is a silicon nitride film forming process by a plasma assisted chemical vapor deposition.

11. The plasma processing apparatus according to claim 10, wherein said apparatus is configured to supply the ammonia gas and the silane-series gas alternately and intermittently, while a purging period is set between an ammonia gas supplying period and a silane-series gas supplying period.

12. The plasma processing apparatus according to claim 7, wherein the plasma gas is a mixed gas of hydrogen and nitrogen, or ammonia gas; and the non-plasma gas is an etching gas, and the process performed by said plasma processing apparatus is a plasma process that removes natural oxide films formed on the process objects.

13. The plasma processing apparatus according to claim 12, the etching gas is nitrogen trifluoride gas.

VACUMMING

PLASMA GAS →
(NH₃)

NON-PLASMA GAS
(HCD)

F I G. I

FIG. 2

F I G. 3

FIG. 4

FIG. 5

FIG. 6

FIG. 7

FIG. 8

FIG. 9

16
14
18
24
24
20
ガス

## FIG. 10

W

**INTERNATIONAL SEARCH REPORT**

| International application No. |
| --- |
| PCT/JP2004/006738 |

| A. CLASSIFICATION OF SUBJECT MATTER |
| --- |
| Int.Cl⁷ H01L21/31, H01L21/3065, C23C16/505, C23F4/00, H05H1/46 |

According to International Patent Classification (IPC) or to both national classification and IPC

| B. FIELDS SEARCHED |
| --- |
| Minimum documentation searched (classification system followed by classification symbols) |
| Int.Cl⁷ H01L21/31, H01L21/3065, C23C16/505, C23F4/00, H05H1/46 |

Documentation searched other than minimum documentation to the extent that such documents are included in the fields searched

| Jitsuyo Shinan Koho | 1922–1996 | Toroku Jitsuyo Shinan Koho | 1994–2004 |
| --- | --- | --- | --- |
| Kokai Jitsuyo Shinan Koho | 1971–2004 | Jitsuyo Shinan Toroku Koho | 1996–2004 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| X Y A | JP 62-159433 A (Hitachi, Ltd.), 15 July, 1987 (15.07.87), Page 2, upper right column, line 1 to lower left column, line 20; Figs. 1, 2 (Family: none) | 1,2,5 3,12,13 6 |
| X Y A | JP 5-251391 A (Tokyo Electron Tohoku Ltd.), 28 September, 1993 (28.09.93), Par. Nos. [0008] to [0017], [0021], [0029], [0030] to [0034]; Figs. 1, 2, 3 (Family: none) | 1,2,4,5 3,7-13 6 |
| Y | JP 6-272035 A (Nippon Steel Corp.), 27 September, 1994 (27.09.94), Claim 1; Par. No. [0015] (Family: none) | 3 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search 04 August, 2004 (04.08.04) | Date of mailing of the international search report 24 August, 2004 (24.08.04) |
| --- | --- |
| Name and mailing address of the ISA/ Japanese Patent Office | Authorized officer |
| Facsimile No. | Telephone No. |

Form PCT/ISA/210 (second sheet) (January 2004)

**INTERNATIONAL SEARCH REPORT**

International application No.

PCT/JP2004/006738

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2002-280378 A  (Hitachi Kokusai Electric Inc.),<br>27 September, 2002 (27.09.02),<br>Par. Nos. [0040] to [0051]<br>(Family: none) | 7-11 |
| Y | JP 2001-284307 A  (F.T.L. Co., Ltd.),<br>12 October, 2001 (12.10.01),<br>Claim 1; Par. Nos. [0004], [0009], [0011] to [0015]<br>& WO 01/73832 A1            & US 2003/148621 A1<br>& AU 4458001 A            & TW 541612 B | 12,13 |
| Y | JP 2003-133284 A  (Kabushiki Kaisha Arubakku),<br>09 May, 2003 (19.05.03),<br>Par. Nos. [0027] to [0032], [0035]; Fig. 3<br>(Family: none) | 12,13 |
| P,X | JP 2003-297818 A  (Hitachi Kokusai Electric Inc.),<br>17 October, 2003 (17.10.03),<br>Par. Nos. [0057] to [0070]; Figs. 5, 6<br>(Family: none) | 1,4,5,7-11 |
| P,X | JP 2004-39795 A  (Hitachi Kokusai Electric Inc.),<br>05 February, 2004 (05.02.04),<br>Par. Nos. [0043] to [0050], [0062] to [0064]; Figs. 4(a), (b)<br>(Family: none) | 1,2,5,7-11 |

Form PCT/ISA/210 (continuation of second sheet) (January 2004)